Europäisches Patentamt

European Patent Office

Office européen des brevets

(19)

(11) Publication number: **0 008 913**
**B1**

(12)

# EUROPEAN PATENT SPECIFICATION

(45) Date of publication of patent specification: **04.08.82**

(21) Application number: **79301730.2**

(22) Date of filing: **23.08.79**

(51) Int. Cl.³: **H 03 G 1/04, H 03 G 3/30, H 04 B 1/00**

(54) **Variable level converter.**

(30) Priority: **29.08.78 JP 105137/78**

(43) Date of publication of application:
**19.03.80 Bulletin 80/6**

(45) Publication of the grant of the patent:
**04.08.82 Bulletin 82/31**

(84) Designated Contracting States:
**DE FR GB IT NL SE**

(56) References cited:
**DE - A - 2 420 502**
**FR - A - 2 285 016**
**US - A - 3 904 975**

(73) Proprietor: **FUJITSU LIMITED**
**1015, Kamikodanaka Nakahara-ku**
**Kawasaki-shi Kanagawa 211 (JP)**

(72) Inventor: **Suzuki, Shinjiro**
**45 Takada-cho, Kohoku-ku**
**Yokohamashi, Kanagawa 223 (JP)**
Inventor: **Yoshikawa, Tadashi**
**2469 Nagatsuda-cho, Midori-ku**
**Yokohamashi, Kanagawa 227 (JP)**
Inventor: **Otsuki, Tsuguo**
**146-1433 Nagatsuda-cho, Midori-ku**
**Yokohamashi, Kanagawa 227 (JP)**
Inventor: **Takeda, Masao**
**973-39 Yano-machi**
**Hachioji-shi Tokyo 192 (JP)**
Inventor: **Kamoi, Nobuhisa**
**466-18 Eda-cho, Midori-ku**
**Yokohamashi, Kanagawa 227 (JP)**
Inventor: **Satoh, Kazuo**
**938 Shukugaware, Tama-ku**
**Kawasaki-shi, Kanagawa 214 (JP)**

(74) Representative: **Abbott, Leonard Charles et al,**
**GILL JENNINGS & EVERY 53/64 Chancery Lane**
**London WC2A 1HN (GB)**

Courier Press, Leamington Spa, England.

Variable level converter

This invention relates to a variable level converter.

The variable level converter, which is one of the most important circuit units in electronic apparatus, generally comprises a conventional variable impedance element, such as an FET (Field Effect Transistor), and a diode or a transistor. The variable level converter is usually used for converting one signal level to another desired signal level under the control of an external level-specifying signal, and also, with an amplifier, for forming an AGC circuit in which the amplifier output is supplied, by way of the feedback loop, as a level-specifying signal to the variable level converter, to keep the output at a desired constant level.

Such a variable level converter is widely employed, for example in a microwave transmitting or receiving system or a satellite communication system.

The variable level converter comprised of one variable impedance element and another circuit element (for example the so-called inverted L-type variable attenuator) is widely known. It can convert one signal level to another desired signal level and can perform the AGC operation, by utilising the so-called non-linear characteristic which is created by the variable impedance element. However, the variable level converter of the prior art has a defect, namely that it is difficult to obtain a wide range of level conversion. This is because when the level is converted in a wide range, a deleterious non-linear distortion, especially a second-order non-linear distortion, is produced from the variable impedance element. In order to maintain a high quality of level conversion, such a second-order non-linear distortion must be eliminated. Further, it is required, for the variable impedance element, to have a wide range of impedance variation so as to obtain a wide range of level conversion. However, if the impedance value varies in a wide range, the noise may increase, due to the second-order non-linear distortion.

It is known, for example in U.S. patent No. 3904975, figure 6, to improve the linearity of the signal attenuation by connecting many identical converter units in series, each unit being controlled by an external signal, derived from a common feedback signal specifying a different level of bias, so that each unit is responsible for the attenuation of only a narrow range of the input signal level. Because only the linear part of the response curve of the units is used, the overall harmonic distortion is low for a wide dynamic range of the input signal. However, a large of number of units is required to obtain good results for a wide dynamic range, as the range of each unit is necessarily narrow.

Therefore, it is an object of the present invention to provide a variable level converter which by itself can perform a wide range of level conversion while suppressing second-order non-linear distortion.

According to the present invention, a variable level converter for converting an input signal from a first input signal level to a second output signal level at an output terminal under the control of a level control signal comprises: a first variable level converting unit which receives the input signal and which includes a parallel-connected first variable impedance element controlled by the level control signal and a first series-connected resistor, and characterized by a second variable level converting unit which produces the output signal, the second variable level converting unit including an amplifying transistor whose base is connected to receive an output from the first variable level converting unit and whose collector is connected to a parallel-connected collector resistor, a second series-connected resistor connected at one end to the collector and the collector resistor, and at the other end to the output terminal and to a parallel-connected second variable impedance element with substantially the same characteristics as the first variable impedance element and controlled by the said level control signal, the output signal at the output terminal being at substantially the same level as, and inverted with respect to, the said output from the first variable level converting unit. Such a converter, whether single-stage or multi-stage, may be used in an AGC circuit.

The present invention will be more apparent from the ensuing description with reference to the accompanying drawings wherein:

Fig. 1 illustrates a circuit diagram of a first embodiment of a variable level converter, according to the present invention; Fig. 2 illustrates a circuit diagram of a P—AGC (Pilot signal AGC) circuit which is constructed by utilising the variable level converter of Fig. 1;

Fig. 3 illustrates a circuit diagram of a second embodiment of a variable level converter, according to the present invention, and

Fig. 4 illustrates a circuit diagram of a P—AGC circuit which is constructed by utilising the variable level converter shown in Fig. 3.

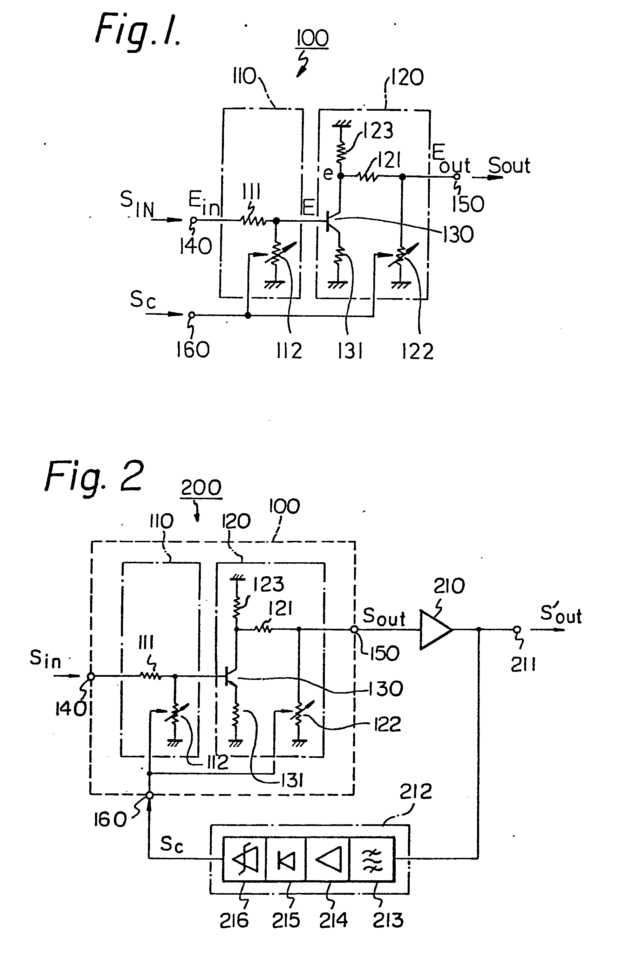

In Fig. 1, the variable level converter 100 is mainly comprised of a first variable level converting unit 110 and a second variable level converting unit 120 including an amplifying transistor 130. The first unit 110 is comprised of a first series resistor 111 and a first variable impedance element 112, such as an FET, a diode or a transistor. The second unit 120 is comprised of the amplifying transistor 130, a second series-connected resistor 121, a second variable impedance element 122, such as a FET, a diode or a transistor, and a parallel-connected resistor 123. The parallel-connected resistor 123 of the second unit 120 serves as a collector resistor for the transistor 130 and a fixed resistor 131

**0 008 913**

serves as its emitter resistor. Thus the transistor 130 forms a grounded-emitter type amplifier; however, a conventional D.C. biasing circuit of this amplifier is not shown in Fig. 1. An input signal $S_{in}$ is applied to the converter 100, via an input terminal 140, and then an output signal $S_{out}$ is produced therefrom, via an output terminal 150, under control of a control signal $S_c$ being supplied via a control terminal 160. The level of the input signal $S_{in}$ is converted to the level of the output signal $S_{out}$, in accordance with the control information indicating the specified value of the level of conversion which is supplied as the control signal $S_c$.

The first unit 110 is known as an inverted L-type variable attenuator. The unit comprising the second series-connected resistor 121 and the second variable impedance element 122 constitutes a second inverted L-type variable attenuator. The known inverted L-type variable attenuator has a defect, that is the level cannot be varied in a wide range without inducing the second-order non-linear distortion, which distortion is produced by the variable impedance element due to the non-linear characteristics thereof. Contrary to the above, the variable level converter of the present invention can vary the level to be converted in a wide range without introducing much second-order non-linear distortion, and accordingly the above mentioned defect is reduced substantially. In order to eliminate the defect completely, the variable level converter would have to satisfy simultaneously the following five conditions:

(1) the converter 100 includes two independent variable impedance elements having identical electric characteristics with each other.

(2) The two variable impedance elements are controlled by the same control signal.

(3) The levels of the signals to be applied to the two variable impedance elements are the same.

(4) The phases of said signals are opposed to each other by 180°.

(5) The transfer functions of the first inverted L-type unit (110) and the second inverted L-type unit (121, 122) are the same.

Condition (3) can only be exactly true for one value of the level of conversion, so all five conditions cannot simultaneously be satisfied fully if the level of conversion is varied continuously.

The operational principle of the present invention will be clarified by the following explanations. The transfer function of the first unit 110 is expressed by the following equation. That is,

$$f(RV_1) = \frac{RV_1}{R_1 + RV_1} \qquad \textcircled{1}$$

where the symbol $RV_1$ represents the resistance value of the first variable impedance element 112, and the symbol $R_1$ represents the resistance value of the resistor 111.

Similarly, the transfer function of the second inverted L-type unit (121, 122) within the second unit 120 is expressed by the following equation. That is,

$$f(RV_2) = \frac{RV_2}{R_2 + RV_2} \qquad \textcircled{2}$$

where the symbol $RV_2$ represents the resistance value of the second variable impedance element 122, and the symbol $R_2$ represents the resistance value of the resistor 121.

Thus $f(RV_2)$ is the ratio between the levels of the output signal $E_{out}$ and the input signal e to the second L-type unit:

$$e.f(RV_2) = E_{out} \qquad \textcircled{2a}$$

The amplifying transistor 130 amplifies the input signal E to the second variable level converting unit 120 to the level of signal e, such that:

$$e = \frac{\dfrac{R_L (R_2 + RV_2)}{R_L + (R_2 + RV_2)}}{Re} .E \qquad \textcircled{2b}$$

Therefore

$$e = \frac{R_L(R_2 + RV_2)}{R_e[R_L + (R_2 + RV_2)]} . E \qquad \textcircled{2c}$$

where $R_L$ is the resistance of resistor 123.

3

Therefore the transfer function of the whole of the second variable level converting unit 120 is as follows:

$$\frac{E_{out}}{E} = f(RV_2) \cdot \frac{e}{E} = \frac{R_L}{R_e} \cdot \frac{RV_2}{R_L + R_2 + RV_2} \qquad \textcircled{2d}$$

Then the total transfer function of the converter 100 is expressed by the following equation. That is,

$$f(RV_1, RV_2) = \frac{E_{out}}{E_{in}} = (\frac{RV_1}{R_1 + RV_1}) \cdot \frac{RL}{R_e} \cdot (\frac{RV_2}{R_2 + RL + RV_2}) \qquad \textcircled{3}$$

where the symbol $R_e$ represents the resistance value of the resistor 131. The symbols $E_{in}$ and $E_{out}$ represent the values of the voltages of the input signal $S_{in}$ and the output signal $S_{out}$, respectively.

With regard to the resistance values $RV_1$ and $RV_2$, these values $RV_1$ and $RV_2$ should satisfy the following equation $\textcircled{4}$, in order to satisfy the aforesaid conditions stated in paragraphs 1) and 2).

$$RV_1 = RV_2 = RV_c \qquad \textcircled{4}$$

where the $RV_c$ is the resistance value of a variable element, when it is controlled by a nominal control signal. Also, the resistance values $R_1$ and $(RL + R_2)$ should be selected so as to satisfy the following equation $\textcircled{5}$, in order to satisfy the aforesaid condition stated in paragraph 5).

$$R_1 = RL + R_2 = R_c \qquad \textcircled{5}$$

where $R_c$ is a constant. Then the total transfer function $f(RV_1, RV_2)$ of the converter 100 is expressed by the following equation $\textcircled{6}$

$$f(RV_1, RV_2) = \frac{RL}{R_e} \cdot (\frac{RV_c}{R_c + RV_c})^2 \qquad \textcircled{6}$$

As will be understood from the above mentioned equations $\textcircled{1}$ and $\textcircled{6}$, the total transfer function $f(RV_1, RV_2)$ is the square of the transfer function of the single inverted L-type variable attenuator, that is the squared transfer function of the first unit 110, and at the same time, the total transfer function $f(RV_1, RV_2)$ has a gain of

$$\frac{RL}{R_e}$$

with respect to the above-mentioned squared transfer function of the first unit 110.

Further, the resistance value $R_e$ can be selected to be some value (explained hereinafter), in order to approximate the aforesaid condition stated in paragraph 3).

Lastly, the aforesaid condition stated in paragraph 4) can be satisfied by employing the grounded-emitter amplifier which includes the transistor 130. This is because the phase of the signal appearing at the collector of the transistor 130 is an opposite phase, by 180°, with respect to the phase of the signal being applied to the base thereof. Consequently, since the levels of the signals to be applied to the first and second variable impedance elements 112 and 122 are the same and at the same time the phases of said signals are an opposite phase with each other, the second-order non-linear distortion is cancelled and cannot be produced from the output terminal 150.

The reason why the second-order non-linear distortion cannot be produced from the output terminal 150, will be more apparent by referring to the following detailed description. Generally, the output voltage E (See Fig.1) of the first unit 110 is expressed by the following equation $\textcircled{7}$.

$$E = a_1 E_{in} + a_2 E_{in}^2 + ... \qquad \textcircled{7}$$

Similarly, the output voltage $E_{out}$ (see Fig. 1) of the second unit 120 is expressed by the following equation $\textcircled{8}$.

$$E_{out} = b_1 (-E) + b_2 (-E)^2 + ... \qquad \textcircled{8}$$

The negative symbols "—" of E are derived from the fact that the phase of the signal appearing at the collector of the transistor 130 is an opposite phase of the signal being applied to the base thereof. In

the above equations $(7)$ and $(8)$, the coefficients $a_1$ and $b_1$ contain only linear factors, such as the transfer functions of the first and second variable level converting units.

The coefficients $a_2$ and $b_2$ represent the second-order non-linear distortion factors. Accordingly, the factors $a_1$ and $b_1$ are represented by the following equations $(9)$ and $(10)$, respectively.

$$a_1 = \frac{RV_1}{R_1 + RV_1} \qquad (9)$$

$$b_1 = \frac{RL}{R_e} \cdot \left( \frac{RV_2}{(R_L + R_2 + RV_2)} \right) \qquad (10)$$

The equation $(10)$ may be rearranged to the following equation $(11)$ by substituting the equations $(4)$ and $(5)$ into the above mentioned equation $(10)$.

$$b_1 = \frac{RL}{R_e} \cdot \left( \frac{RV_1}{R_1 + RV_1} \right) \qquad (11)$$

The above mentioned equation $(8)$ may be rearranged to the following equation $(12)$ by substituting the equation $(7)$ into this equation $(8)$.

$$E_{out} = b_1(-a_1 E_{in} - a_2 E_{in}^2 \ldots) + b_2(-a_1 E_{in} - a_2 E_{in}^2 \ldots)^2$$
$$= -a_1 b_1 E_{in} + (a_1^2 b_2 - a_2 b_1) E_{in}^2 + \ldots \qquad (12)$$

Then the second-order non-linear distortion factor is derived from this equation $(12)$, which factor is represented by the coefficient of $E_{in}2$, that is $(a_1^2 b_2 - a_2 b_1)$. It should be noted that if the factor $(a_1^2 b_2 - a_2 b_1)$ equals zero, the second-order non-linear distortion $(E_{in}^2)$ cannot be produced from the converter 100. It is well known that, for any circuit such as this, the second-order non-linear distortion $(a_2)$ introduced by the first unit equals the product of that introduced by the second unit $(b_2)$ and the square of the value of the transmission loss $(a_1)$, that is:

$$a_2 = a_1^2 b_2 \qquad (13)$$

The factor $(a_1^2 b_2 - a_2 b_1)$ can therefore be expressed by the following equation, that is:

$$a_1^2 b_2 - a_2 b_1 = a_1^2 b_2 - a_1^2 b_2 \, b_1 = a_1^2 b_2 (1 - b_1) \qquad (14)$$

by using the known fact that the value $a_2$ equals the value $a_1^2 b_2$.

Therefore, in the above mentioned equation $(14)$, the factor $(a_1^2 b_2 - a_2 b_1)$, or $a_1^2 b_2(1 - b_1)$, is caused to be zero by selecting the value of $b_1$ to be equal to 1. In other words, from the equation $(11)$, the value of

$$\frac{RL}{R_e} \cdot \frac{RV_1}{(R_1 + RV_1)}$$

should ideally be equal to 1. It should be remembered that in the previously mentioned statement, with reference to the equation $(6)$, "the resistance value $R_e$ can be selected to be some value in order to approximate the aforesaid condition stated in paragraph 3)". It has now been shown that the value of $R_e$ should ideally be equal to

$$RL \cdot \frac{RV_1}{R_1 + RV_1}$$

because the value

$$\frac{RL}{R_e} \cdot \frac{RV_1}{R_1 + RV_1}$$

should be equal to 1, in order completely to suppress the second-order non-linear distortion. However, as explained above, in actual operation, the input signal level necessarily varies and, accordingly the AGC level also varies. In such actual operation, according to the present invention, although the second-order non-linear direction cannot completely be cancelled, it can be greatly suppressed. Thus $RV_1$ varies over a wide range, and this condition can only be satisfied completely for one value of $RV_1$. This value may be a predetermined nominal value within the range of values of $RV_1$, so as to optimise the suppression of distortion over the whole operative range of the control signal.

As a result, the transfer function $f(RV_1, RV_2)$ of the converter 100 becomes a squared function $f(RV_1)$ of the single inverted L-type variable attenuator (see the equation $\textcircled{6}$), and accordingly the logarithmic conversion ratio of the level may be twice the conversion ratio which is obtained by using the single inverted L-type variable attenuator. For example, the conversion ratio of such an attenuator is 20 dB, while the conversion ratio of the converter 100 becomes about 40 dB. As previously mentioned, with reference to the paragraph 3), the levels of the signals to be applied to the two variable impedance elements 112 and 122 must be the same. Such level coincidence is created by the amplifier being comprised of the transistor 130, because the transmission loss in the unit 110 is compensated by the transistor 130. In this case, it is preferable to create the level coincidence completely, when it is desired to eliminate the second-order distortion completely, the levels of signals applied to the variable impedance elements 112 and 122 may be slightly different from each other.

The variable level converter 100 may preferably be employed in an AGC circuit. The AGC circuit which utilizes the converter 100 is illustrated in Fig. 2, which AGC circuit 200 is especially directed to a P—AGC (Pilot signal AGC) circuit. In Fig. 2, members which have the same reference numerals or symbols as those shown in Fig. 1 are identical with each other. The reference numeral 210 represents an amplifier having a fixed gain. An amplified signal $S_{out}$ from the amplifier 210 is, on the one hand, produced, as an output signal $S'_{out}$, from an output terminal 211, and, on the other hand, applied to a feedback circuit 212. The feedback circuit 212 is comprised of a pilot filter 213, a pilot signal amplifier 214, a rectifier 215 and an expander 216. The output signal from this feedback circuit 212 is applied, as the control signal $S_c$, to the control terminal 160. The pilot filter 213 operates so as to extract the pilot signal from the signal $S_{in}$. The extracted pilot signal is amplified by the pilot signal amplifier 214, and the amplified pilot signal is changed to a $d_c$ voltage pilot signal by means of the rectifier 215. The $d_c$ voltage pilot signal is converted to the expanded $d_c$ voltage pilot signal, by means of the expander 216, in accordance with an appropriate expansion characteristic which is suitable for normally controlling both the variable impedance elements 112 and 122. The operation of the converter 100 has already been explained by referring to Fig. 1. The feedback circuit 212 controls the variable impedance elements 112 and 122 so as to increase or decrease the gain of the converter 100 when the level of the pilot signal decreases or increases, respectively, due to, for example a fading. Thus, the feedback loop, which is formed between the output of the amplifier 210 and the control terminal 160, acts as a negative feedback loop. As already mentioned, the converter 100 creates twice the logarithmic conversion ratio which is obtained by using the inverted L-type variable attenuator such as the first variable level converting unit 110. Accordingly, The P—AGC circuit 200 succeeds in providing the automatic-gain-controlled dynamic range which is provided by a conventional P—AGC circuit being comprised of the inverted L-type variable attenuator. At the same time, the P—AGC circuit 200 produces no second-order non-linear distortion.

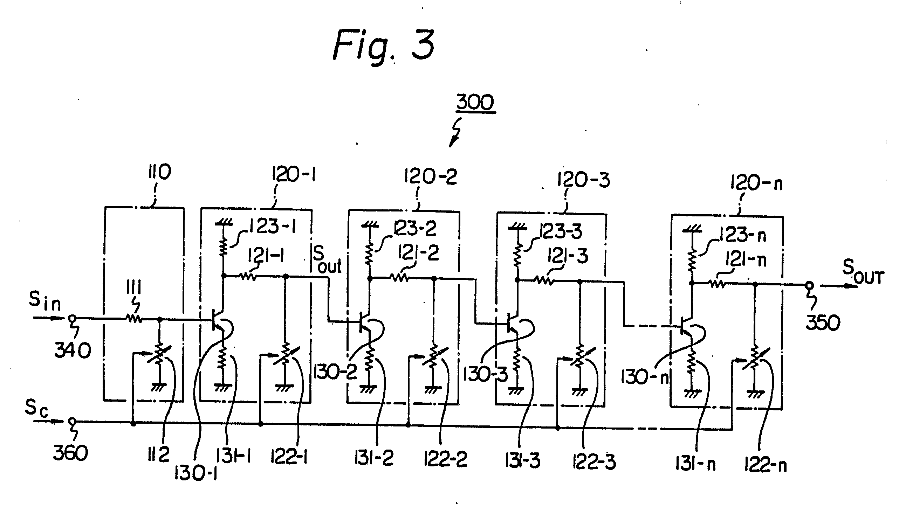

The level conversion ratio can easily be expanded at will by forming a multiple-stage variable level converter, based on the converter 100 of Fig. 1. In Fig. 3, which illustrates a circuit diagram of a second embodiment of a variable level converter, the multiple-stage variable level converter 300 is comprised of the first variable level converting unit 110 (see Fig. 1), the "n" numbers of the second variable level converting units 120—1, 120—2, 120—3 .... 120—n (refer to the second variable level converting unit 120 of Fig. 1) and the "n" numbers of the amplifying transistors 130—1, 130—2, 130—3 .... 130—n (refer to the amplifying transistor 130 of Fig. 1). The fixed resistors 111 of Figs. 3 and 1 are identical. The first variable impedance elements 112 of Figs. 3 and 1 are identical. Each of the first fixed resistors 121—1, 121—2, 121—3 ..... 121—n of Fig. 3 and the first fixed resistor 121 are identical. Each of second variable impedance elements 122—1, 122—2, 122—3 ..... 122—n of Fig. 3 and the second variable impedance element 122 of Fig. 1 are identical. Each of second fixed resistors 123—1, 123—2, 123—3 ..... 123—n of Fig. 3 and the second fixed resistor 123 of Fig. 1 are identical. Each of the fixed reactors 131—1, 131—2, 131—3 ..... 131—n of Fig. 3 and the fixed resistor 131 of Fig. 1 are identical. The reference numerals 340, 350 and 360, respectively represent an input terminal, an output terminal and a control terminal. Signals $S_{in}$ and $S_c$ of Fig. 3 are, respectively, identical with the signals $S_{in}$ and $S_c$ of Fig. 1. The reference symbol $S_{OUT}$ is an output signal which is different from the above mentioned output signal $S_{out}$.

When each of the variable level converting units 120—1, 120—2, 120—3 ..... 120—n is following equation $\textcircled{15}$ is obtained.

$$RV_1 = RV_{2-1} = RV_{2-2} = RV_{2-3} \cdots RV_{2-n} = RV_c \qquad \textcircled{15}$$

The meaning of these symbols are similar to the meaning of the corresponding symbols occurring in the equation $\textcircled{4}$.

The resistance values of the resistors 111, 121—1 through 121—n and 123—1 through 123—n should be selected so as to satisfy the following equation $\textcircled{16}$.

6

$$R_1 = RL_1 + R_{2-1} = RL_2 + R_{2-2} = RL_3 + R_{2-3} \ldots = RL_n + R_{2-n} = R_c \qquad (16)$$

The meaning of these symbols are similar to the meaning of the corresponding symbols occurring in the equation $(5)$:

Therefore, the total transfer function $f(RV_1 \ldots RV_n)$ is expressed by the following equation $(17)$

$$f(RV_1 \ldots RV_n) = (\frac{RL_1}{R_{e1}} \cdot \frac{RL_2}{R_{e2}} \ldots \frac{RL_n}{R_{en}}) \cdot (\frac{RV_c}{R_c + RV_c})^{n+1} \qquad (17)$$

The meaning of these symbols are similar to the meaning of the corresponding symbols occurring in the equation $(6)$. Since the ground-emitter type amplifiers in respective variable level converting units 120—1 through 120—n have identical characteristics with each other, each of the collector resistors (RL) of the transistors 130—1 through 130—n and each of the emitter resistors $(R_e)$ thereof satisfy the following equations $(18)$ and $(19)$

$$RL_1 = RL_2 = RL_3 \ldots RL_n = RL_c \qquad (18)$$

$$R_{e1} = R_{e2} = R_{e3} \ldots R_{en} = R_{ec} \qquad (19)$$

Therefore, the equation $(17)$ can be replaced by the following equation $(20)$.

$$f(RV_1 \ldots RV_n) = (\frac{RL_c}{R_{ec}})^n \cdot (\frac{RV_c}{R_c + RV_c})^{n+1} \qquad (20)$$

As will be understood from the equation $(20)$, the logarithmic conversion ratio of the converter 300 becomes (n+l) times the conversion ratio which is obtained by using the single inverted L-type variable attenuator.

Departing from the equation $(20)$, suppose that each gain

$$(\frac{RL_1}{R_{e1}}, \frac{RL_2}{R_{e2}}, \frac{RL_3}{R_{e3}} \ldots \frac{RL_n}{R_{en}})$$

of the respective stages (120—1, 120—2, 120—3 ... 120—n) is selected so as to satisfy the following equation $(21)$.

$$\frac{RL_1}{R_{e1}} = \frac{RL_2}{R_{e2}} = \frac{RL_3}{R_{e3}} \ldots = \frac{RL_n}{R_{en}} = \frac{RV(0) + R_c}{RV(0)} \qquad (21)$$

The symbol RV(0) represents a specified resistance value of each variable impedance element when a respective predetermined standard input voltage according to the so-called level diagram, is supplied thereto. Consequently, the equation $(20)$ can be rewritten to become the following equation $(21)$.

$$f(RV_1 \ldots RVn) = \frac{RV(0)}{RV(0) + R_c} \qquad (22)$$

As will be understood from the equation $(22)$, the transmission loss created between the input terminal 340 and the output terminal 350 is almost equal to the transmission loss created by the first unit 110 (refer to the equation $(1)$). In other words, there is not transmission loss between the units 120—1 through 120—n. Accordingly, the above mentioned level diagram between the units 120—1 through 120—n does not change. As a result, during the application of said predetermined standard input voltage to each unit (120—1 through 120—n), the levels of the signals applied to the respective variable impedance elements 122—1 through 122—n are the same, and thereby the previously mentioned condition stated in the paragraph 3) can be satisfied. Also, the phases of said signals appearing in each two adjacent units (110, 120—1), (120—1, 120—2) ... (120—(n—1), 120—n) are opposite to each other by 180°, and accordingly the previously mentioned condition stated in the paragraph 4) can be satisfied. Thereby, the second-order non-linear distortion cannot be provided from the output terminal 350.

The variable level converter 300 may also preferably be employed in an AGC circuit. The AGC

# 0 008 913

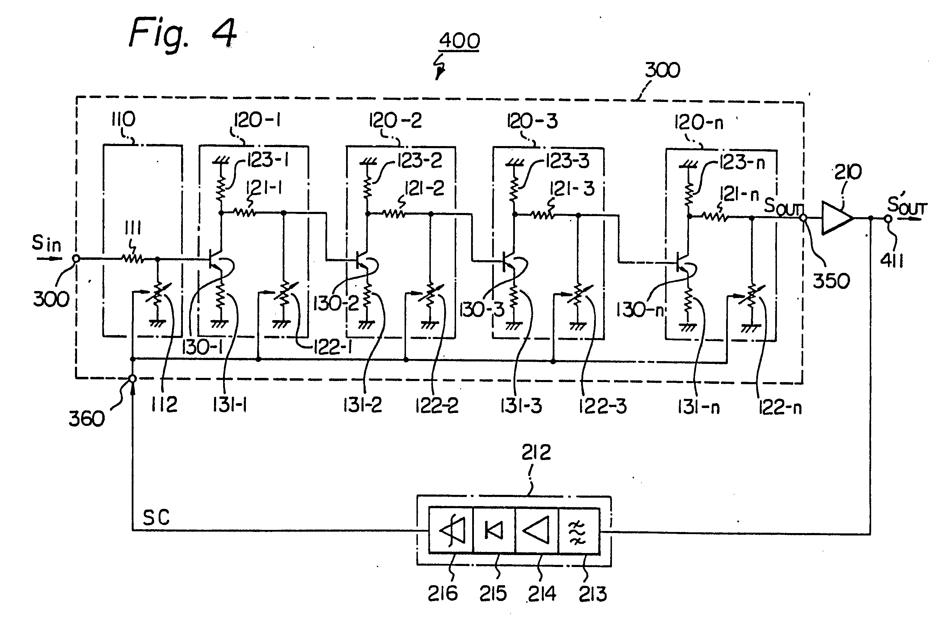

circuit which utilizes the converter 300 is illustrated in Fig. 4, which AGC circuit 400 is especially directed to the P—AGC (Pilot signal AGC) circuit. In Fig. 4, members which have the same reference numerals or symbols as those shown in Figs. 2 and 3 are identical with each other. An amplified signal $S_{OUT}$ from the amplifier 210 is, on the one hand, produced as an output signal $S'_{OUT}$, from an output terminal 411, and, on the other hand, applied to the feedback circuit 212. The operation of the converter 300 has already been explained by referring to Fig. 3. As has already been mentioned, the converter 300 attains (n+1) times the conversion ration which is obtained by using the inverted L-type variable level converting unit 110. Accordingly, the P—AGC circuit 400 succeeds in providing n times an automatic-gain-controlled dynamic range which will be provided by a conventional P—AGC circuit comprised of the inverted L-type variable attenuator. At the same time, the P—AGC circuit 400 produces no second- order non-linear distortion, if the equation (22) is also satisfied.

As mentioned above, the variable level converter of the present invention can provide a very wide dynamic range of the level to be converted, when compared to the dynamic range of the levels obtained by using the conventional inverted L-type variable attenuator. Further, although the variable level converter of the present invention provides a very wide dynamic range, it produces almost no second-order non-linear distortion, by suitably choosing the circuit elements so as to satisfy the aforesaid equations. Thus, the variable level converter will be very useful for the AGC circuit employed in microwave transmitting and receiving systems or a satellite communication system, which AGC circuit is required to attain a very wide range of level conversion without inducing the second-order non-linear distortion.

## Claims

1. A variable level converter for converting an input signal ($S_{in}$) from a first input signal level ($E_{in}$) to a second output signal level ($E_{out}$) at an output terminal (150) under the control of a level control signal ($S_c$), comprising a first variable level converting unit (110) which receives the input signal and which includes a parallel-connected first variable impedance element (112) controlled by the level control signal ($S_c$) and a first series-connected resistor (111), and characterized by a second variable level converting unit (120) which produces the output signal, the second variable level converting unit including an amplifying transistor (130) whose base is connected to receive an output (E) from the first variable level converting unit (110) and whose collector is connected to a parallel-connected collector resistor (123), a second series-connected resistor (121) connected at one end to the collector and the collector resistor, and at the other end to the output terminal and to a parallel-connected second variable impedance element (122) with substantially the same characteristics as the first variable impedance element and controlled by the said level control signal ($S_c$), the output signal at the output terminal being at substantially the same level as, and inverted with respect to, the said output from the first variable level converting unit.

2. A multi-stage variable level converter having a converter as set forth in claim 1 serving as the first stage, characterized in that each additional stage is comprised of the said second variable level converting unit (120—2 to 120—n), all the stages being connected in a series, the transistor of each additional stage receiving the output of the preceding stage, the last stage providing the output signal of the multi-stage converter.

3. A converter as set forth in claim 1 or 2, characterised in that each of the amplifying transistors forms, with collector and emitter resistors, (123, 131), a grounded-emitter amplifier circuit.

4. A converter as set forth in claim 1, characterized in that an amplifier (210, Fig. 2) is connected to receive the output from the second variable level converting unit, a part of the output from the amplifier being supplied, as the level control signal, to each of the variable impedance elements so as to form a negative feedback loop.

5. A converter as set forth in claim 2, characterized in that an amplifier (210, Fig. 4) is connected to receive the output of the last stage of the converter, a part of the output from the amplifier being supplied, as the level control signal, to all the variable impedance elements so as to form a negative feedback loop.

6. A converter as set forth in claim 4 or 5, characterized in that the level control signal is a pilot signal included in the input signal.

## Patentansprüche

1. Variabler Pegelumsetzer zum Umsetzen eines Eingangssignals ($S_{in}$) von einem ersten Eingangs-signalpegel ($E_{in}$) in einen zweiten Ausgangssignalpegel ($E_{out}$) an einem Ausgangsanschluß (150) unter der Steuerung eines Pegelsteuersignals ($S_c$) mit einer ersten variablen Pegelumsetzeinheit (110), die das Eingangssignal empfängt und die ein parallel geschaltetes erstes variables Impedanzelement (112), das durch das Pegelsteuersignal ($S_c$) gesteuert wird, und einen ersten reihengeschalteten Widerstand (111) enthält, gekennzeichnet durch eine zweite variable Pegelumsetzeinheit (120), die das Ausgangssignal erzeugt, wobei die zweite variable Pegelumsetzeinheit einen Verstärkertransistor (130), dessen

8

Basis so geschaltet ist, daß sie ein Ausgangssignal (E) von der ersten variablen Pegelumsetzeinheit (110) empfängt, und dessen Kollektor mit einem parallel geschalteten Kollektorwiderstand (123) verbunden ist, und einen zweiten reihengeschalteten Widerstand (121) enthält, der an einem Ende mit dem Kollektor und dem Kollektorwiderstand verbunden ist und an dem anderen Ende mit dem Ausgangsanschluß und mit einem parallel geschalteten zweiten variablen Impedanzelement (122), das im wesentlichen dieselben Eigenschaften wie das erste variable Impedanzelement aufweist und das durch das Pegelsteuersignal ($S_c$) gesteuert wird, verbunden ist, wobei sich das Ausgangssignal an dem Ausgangsanschluß im wesentlichen auf demselben Pegel wie das Ausgangssignal, jedoch dazu umgekehrt, von der ersten variablen Pegelumsetzeinheit befindet.

2. Mehrstufiger variabler Pegelumsetzer mit einem Umsetzer nach Anspruch 1, der als erste Stufe dient, dadurch gekennzeichnet, daß jede zusätzliche Stufe aus der zweiten variablen Pegelumsetzeinheit (120—2 bis 120—n) besteht, wobei alle Stufen in Reihe geschaltet sind, wobei der Transistor jeder zusätzlichen Stufe das Ausgangssignal der vorangehenden Stufe empfängt und wobei die letzte Stufe das Ausgangssignal des mehrstufigen Umsetzers erzeugt.

3. Umsetzer nach Anspruch 1 oder 2, dadurch gekennzeichnet, daß jeder der Verstärkertransistoren mit Kollektor- und Emitterwiderständen (123, 131) einen Verstärkerkreis in Emitterschaltung bildet.

4. Umsetzer nach Anspruch 1, dadurch gekennzeichnet, daß ein Verstärker (210, Fig. 2) so geschaltet ist, daß er das Ausgangssignal von der zweiten variablen Pegelumsetzeinheit empfängt, wobei ein Teil des Ausgangssignals von dem Verstärker als Pegelsteuersignal jedem der variablen Impedanzelements zugeführt wird, um eine negative Rückkopplungsschleife zu bilden.

5. Umsetzer nach Anspruch 2, dadurch gekennzeichnet, daß ein Verstärker (210, Fig. 4) so geschaltet ist, daß er das Ausgangssignal der letzten Stufe des Umsetzers empfängt, wobei ein Teil des Ausgangssignals von dem Verstärker als Pegelsteuersignal allen variablen Impedanzelementen zugeführt wird, um eine negative Rückkopplungsschleife zu bilden.

6. Umsetzer nach Anspruch 4 oder 5, dadurch gekennzeichnet, daß das Pegelsteuersignal ein in dem Eingangssignal enthaltenes Pilotsignal ist.

**Revendications**

1. Un convertisseur de niveau variable permettant de convertir un signal d'entrée ($S_{in}$) d'un premier niveau de signal d'entrée ($E_{in}$) à un deuxième niveau de signal de sortie ($E_{out}$), en une borne de sortie (150), sous commande d'un signal de commande de niveau ($S_c$), comprenant une première unité de conversion de niveau variable (110) qui reçoit le signal d'entrée et qui comporte un premier élément à impédance variable connecté en parallèle (112) commandé par le signal de commande de niveau et une première résistance connectée en série (111), et careactérisé par un deuxième unité de conversion de niveau variable (120) qui produit le signal de sortie, la deuxième unité de conversion de niveau variable comportant un transistor amplificateur (130) dont la base est connectée de façon à recevoir un signal de sortie (E) de la première unité de conversion de niveau variable (110) et dont le collecteur est connecté à une résistance de collecteur connectée en parallèle (123), une deuxième résistance connectée en série (121) connectée par une extrémité au collecteur et à la résistance de collecteur, et, par l'autre extrémité, à la borne de sortie et à un deuxième élément à impédance variable connecté en parallèle (122) ayant sensiblement les mêmes caractéristiques que le premier élément à impédance variable et commandé par ledit signal de commande de niveau ($S_c$), le signal de sortie présent sur la borne de sortie étant sensiblement du même niveau, et inversé par rapport à celui-ci, que ledit signal de sortie de la première unité de conversion de niveau variable.

2. Un convertisseur de niveau variable à plusieurs étages possédant un convertisseur tel que décrit dans la revendication 1 qui sert de premier étage, caractérisé en ce que chaque étage supplémentaire est constitué de ladite unité de conversion de niveau variable (120—2 à 120—n), tous les étages étant connectés en série, le transistor de chaque étage supplémentaire recevant le signal de sortie de l'étage précédant, le dernier étage produisant le signal de sortie du convertisseur à plusieurs étages.

3. Un convertisseur tel que décrit dans la revendication 1 ou 2, caractérisé en ce que chacun des transistor amplificateurs forme, avec des résistances de collecteur et d'émetteur (123, 131), un circuit amplificatuer à émetteur à la terre.

4. Un convertisseur tel que décrit dans la revendication 1, caractérisé en ce qu'un amplificateur (210, figure 2) est connecté de façon à recevoir le signal de sortie de la deuxième unité de conversion de niveau variable, une partie du signal de sortie de l'amplificateur étant délivrée, comme signal de commande de niveau, à chacun des éléments à impédance variable de façon à former une boucle de réaction négative.

5. Un convertisseur tel que décrit dans la revendication 2, caractérisé en ce qu'un amplificateur (210, figure 4) est connecté de façon à recevoir le signal de sortie du dernier étage du convertisseur, une partie du signal de sortie de l'amplificateur étant délivrée, comme signal de commande de niveau, à tous les éléments à impédance variable de façon à former une boucle de réaction négative.

6. Un convertisseur tel que décrit dans la revendication 4 ou 5, caractérisé en ce que le signal de commande de niveau est un signal pilote inclus dans le signal d'entrée.

## Fig. 1.

## Fig. 2

# Fig. 3

0 008 913

Fig. 4